(19) Europäisches Patentamt
European Patent Office
Office européen des brevets

(11) **EP 3 998 488 A1**

(12) **EUROPÄISCHE PATENTANMELDUNG**

(43) Veröffentlichungstag:
**18.05.2022 Patentblatt 2022/20**

(21) Anmeldenummer: **21205917.4**

(22) Anmeldetag: **02.11.2021**

(51) Internationale Patentklassifikation (IPC):
***G01R 31/389*** *(2019.01)*

(52) Gemeinsame Patentklassifikation (CPC):
**G01R 31/389**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**KH MA MD TN**

(30) Priorität: **30.10.2020 DE 102020128639**

(71) Anmelder: **TWAICE Technologies GmbH**
**80807 München (DE)**

(72) Erfinder:
• **ATUKALP, Devin**
**81735 München (DE)**
• **KONDAVALASA, Saiveer Patnaik**
**97080 Würzburg (DE)**
• **BERG, Philipp**
**81827 München (DE)**

(74) Vertreter: **Neusser, Sebastian**
**Kraus & Weisert**
**Patentanwälte PartGmbB**
**Thomas-Wimmer-Ring 15**
**80539 München (DE)**

(54) **WIDERSTANDSABSCHÄTZUNG FÜR BATTERIEZELLEN EINER WIEDERAUFLADBAREN BATTERIE**

(57) Es wird eine Widerstandsabschätzung basierend auf einer Abfolge von mindestens zwei Spannung-Strom-Wertepaaren mindestens einer Batteriezelle einer Batterie erhalten, wobei die Abfolge der mindestens zwei Spannung-Strom-Wertepaare assoziiert ist mit bestimmten Werten für mindestens zwei Betriebsparameter der mindestens einen Batteriezelle der Batterie. Außerdem wird, basierend auf der Widerstandsabschätzung, ein Eintrag in einer Datenstruktur, der mit den bestimmten Werten für die mindestens zwei Betriebsparameter assoziiert ist, geändert.

FIG. 5

EP 3 998 488 A1

**Beschreibung**

TECHNISCHES GEBIET

Verschiedene Beispiele betreffen allgemein das Sammeln und Prozessieren von Informationen betreffend einen Widerstand von einer oder mehreren Batteriezellen einer wiederaufladbaren Batterie. Insbesondere kann eine Filterung von Widerstandsabschätzungen erfolgen, um Messartefakte oder Rauschen zu unterdrücken. Derart kann eine nachfolgende Zustandsbestimmung von einem oder mehreren Zustandswerten an der Batterie besonders zuverlässig und robust erfolgen.

HINTERGRUND

Wiederaufladbare Batterien werden in verschiedenen Anwendungsszenarien eingesetzt. Ein Beispiel sind Traktionsbatterien in Elektrofahrzeugen oder auch stationäre Energiespeicher, z.B. um Lastspitzen in einem Stromnetz abzufedern.

In den verschiedenen Anwendungsszenarien ist es typischerweise hilfreich, Zustandswerte der Batterie besonders genau zu bestimmen. Zum Beispiel ist es erstrebenswert, den Alterungszustand der Batterie zu bestimmen.

Dabei ist es oftmals hilfreich, eine Abschätzung für einen Widerstand der Batterie zu erhalten. Dabei wurde beobachtet, dass es im laufenden Betrieb der Batterie oftmals schwierig sein kann, einen aussagekräftigen Wert für den Widerstand, d.h., eine zuverlässig ermittelte Widerstandsabschätzung, basierend auf entsprechenden Messwerten für Spannung und Strom zu bestimmen.

KURZE ZUSAMMENFASSUNG DER ERFINDUNG

Deshalb besteht ein Bedarf für verbesserte Techniken zum Bestimmen einer Widerstandsabschätzung für mindestens eine Batteriezelle einer Batterie.

Diese Aufgabe wird gelöst von den Merkmalen der unabhängigen Patentansprüche. Die Merkmale der abhängigen Patentansprüche definieren Ausführungsformen. Ein Verfahren umfasst das Erhalten einer Widerstandsabschätzung. Die Widerstandsabschätzung basiert auf einer Abfolge von mindestens zwei Spannung-Strom-Wertepaaren mindestens einer Batteriezelle einer Batterie. Diese Abfolge ist assoziiert mit bestimmten Werten für mindestens zwei Betriebsparameter der mindestens einen Batteriezelle der Batterie. Das Verfahren umfasst das Ändern eines Eintrags in einer Datenstruktur basierend auf der Widerstandsabschätzung. Dabei ist der Eintrag mit den bestimmten Werten für die mindestens zwei Betriebsparameter assoziiert. Der Eintrag umfasst zum Beispiel zumindest eine statistische Kenngröße einer Vielzahl von Widerstandsabschätzungen für die bestimmten Werte der mindestens zwei Betriebsparameter. Die Vielzahl von Widerstandsabschätzungen umfasst dabei die Widerstandsabschätzung, die auf der Abfolge von mindestens zwei Spannung-Strom-Wertepaaren basiert, sowie mehrere weitere Widerstandsabschätzungen für die bestimmten Werte der mindestens zwei Betriebsparameter. Der Eintrag könnte auch einen modellbasierten Vorhersagewert für ein Widerstand der Batterie umfassen, der basierend auf der Vielzahl von Widerstandsabschätzungen bestimmt wird.

Die Widerstandsabschätzung bezeichnet also einen Schätzwert für den Widerstand, etwa den DC-Widerstand, in der mindestens einen Batteriezelle. Dieser kann auf Messdaten basieren.

Die mehreren weiteren Widerstandsabschätzungen können zu einem früheren Zeitpunkt (bei denselben Werten der Betriebsparameter) erhalten worden sein.

Verschiedene Einträge der Datenstruktur sind mit unterschiedlichen Werten der mindestens zwei Betriebsparameter assoziiert.

Mittels solcher Techniken ist es also möglich, eine Datenstruktur zu erzeugen, die mehrere Einträge aufweist, die strukturiert sind hinsichtlich der Werte der mindestens zwei Betriebsparameter. Je Eintrag der Datenstruktur kann eine entsprechende statistische Kenngröße für eine entsprechende Vielzahl von Widerstandsabschätzungen bereitgestellt werden. Diese statistische Kenngröße bezeichnet also eine statistische Charakteristik der Vielzahl von Widerstandsabschätzungen für die entsprechenden Werte der mindestens zwei Betriebsparameter. Derart können einerseits Abhängigkeiten der Widerstandsabschätzung von den Werten der Betriebsparameter berücksichtigt werden. Andererseits können auch statistische Fluktuationen der Widerstandsabschätzungen, beispielsweise aufgrund von Messungenauigkeiten oder Messrauschen, berücksichtigt werden, indem nämlich die statistische Kenngröße bereitgestellt wird. Dadurch kann es ermöglicht werden, anschließende Anwendungen, die auf der Widerstandsabschätzung basieren, zuverlässig und mit einer genauen Schätzung für den Widerstand zu betreiben.

Beispiele für Betriebsparameter sind zum Beispiel: Temperatur; Ladungszustands; Stromstärke, beispielsweise normiert auf die Lade- oder Entladerate (C-Rate), Absolutwert der Stromstärke, usw.

Ein Computerprogramm oder ein Computerprogramm-Produkt oder ein computerlesbares Speichermedium umfasst Programmcode, der von mindestens einem Prozessor ausgeführt werden kann. Wenn der Prozessor den Programmcode ausführt, bewirkt dies, dass der Prozessor ein Verfahren ausführt. Das Verfahren umfasst das Erhalten einer Widerstandsabschätzung. Die Widerstandsabschätzung basiert auf einer Abfolge von mindestens zwei Spannung-Strom-Wertepaaren mindestens einer Batteriezelle einer Batterie. Diese Abfolge ist assoziiert mit bestimmten Werten für mindestens zwei Betriebsparameter der mindestens einen Batteriezelle der Batterie. Das Verfahren umfasst das Ändern eines Eintrags in einer Datenstruktur basierend auf der Widerstandsabschätzung. Dabei ist der Eintrag mit den bestimmten Werten für die mindestens zwei Betriebsparameter assoziiert. Der Eintrag umfasst beispielsweise zumindest eine statistische Kenngröße einer Vielzahl von Widerstandsabschätzungen für die bestimmten Werte der mindestens zwei Betriebsparameter. Die Vielzahl von Widerstandsabschätzungen umfasst dabei die Widerstandsabschätzung, die auf der Abfolge von mindestens zwei Spannung-Strom-Wertepaaren basiert, sowie mehrere weitere Widerstandsabschätzungen für die bestimmten Werte der mindestens zwei Betriebsparameter.

Ein Gerät umfasst einen Prozessor, der eingerichtet ist, um folgende Schritte auszuführen: Erhalten einer Widerstandsabschätzung basierend auf einer Abfolge von mindestens zwei Spannung-Strom-Wertepaaren mindestens einer Batteriezelle einer Batterie, wobei die Abfolge der mindestens zwei Spannung-Strom-Wertepaare assoziiert ist mit bestimmten Werten für mindestens zwei Betriebsparameter der mindestens einen Batteriezelle der Batterie, und basierend auf der Widerstandsabschätzung, Ändern eines Eintrags in einer Datenstruktur, der mit den bestimmten Werten für die mindestens zwei Betriebsparameter assoziiert ist, wobei der Eintrag beispielsweise zumindest eine statistische Kenngröße einer Vielzahl von Widerstandsabschätzungen für die mindestens zwei Betriebsparameter umfasst, wobei die Vielzahl von Widerstandsabschätzungen die Widerstandsabschätzung und mehrere weitere Widerstandsabschätzungen für die bestimmten Werte der mindestens zwei Betriebsparameter umfasst.

Die oben dargelegten Merkmale und Merkmale, die nachfolgend beschrieben werden, können nicht nur in den entsprechenden explizit dargelegten Kombinationen verwendet werden, sondern auch in weiteren Kombinationen oder isoliert, ohne den Schutzumfang der vorliegenden Erfindung zu verlassen.

KURZE BESCHREIBUNG DER FIGUREN

FIG. 1 illustriert schematisch ein System umfassend mehrere Batterien und einen Server gemäß verschiedenen Beispielen.

FIG. 2 illustriert Details einer Batterie gemäß verschiedenen Beispielen.

FIG. 3 illustriert Details eines Servers gemäß verschiedenen Beispielen.

FIG. 4 ist ein Flussdiagramm eines Verfahrens gemäß verschiedenen Beispielen.

FIG. 5 illustriert eine Verteilung einer Vielzahl von Widerstandsabschätzungen gemäß verschiedenen Beispielen.

FIG. 6 ist ein Flussdiagramm eines Verfahrens gemäß verschiedenen Beispielen.

DETAILLIERTE BESCHREIBUNG VON AUSFÜHRUNGSFORMEN

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden.

Nachfolgend wird die vorliegende Erfindung anhand bevorzugter Ausführungsformen unter Bezugnahme auf die Zeichnungen näher erläutert. In den Figuren bezeichnen gleiche Bezugszeichen gleiche oder ähnliche Elemente. Die Figuren sind schematische Repräsentationen verschiedener Ausführungsformen der Erfindung. In den Figuren dargestellte Elemente sind nicht notwendigerweise maßstabsgetreu dargestellt. Vielmehr sind die verschiedenen in den Figuren dargestellten Elemente derart wiedergegeben, dass ihre Funktion und genereller Zweck dem Fachmann verständlich wird. In den Figuren dargestellte Verbindungen und Kopplungen zwischen funktionellen Einheiten und Elementen können auch als indirekte Verbindung oder Kopplung implementiert werden. Eine Verbindung oder Kopplung kann drahtgebunden oder drahtlos implementiert sein. Funktionale Einheiten können als Hardware, Software oder eine Kombination aus Hardware und Software implementiert werden.

Nachfolgend werden Techniken im Zusammenhang mit der Charakterisierung von wiederaufladbaren Batterien beschrieben. Die hierin beschriebenen Techniken können im Zusammenhang mit unterschiedlichsten Typen von Batterien eingesetzt werden, beispielsweise im Zusammenhang mit Batterien auf Lithium-Ionen-Basis, wie z.B. Lithium-Nickel-Mangan-Kobaltoxid-Batterien oder Lithium-Manganoxid-Batterien.

Die hierin beschriebenen Batterien können für Batterien in unterschiedlichen Anwendungsszenarien eingesetzt werden, beispielsweise für Batterien die in Geräten wie Kraftfahrzeugen oder Drohnen oder tragbaren elektronischen Geräten wie etwa Mobilfunkgeräte eingesetzt werden, etwa Traktionsbatterien. Es wäre auch denkbar, die hierin beschriebenen Batterien in Form von stationären Energiespeichern einzusetzen. Innenraum- oder Außenraumanwendungen sind denkbar, die sich vor allem hinsichtlich der Temperaturbereiche unterscheiden. Anwendungsszenarien umfassen: stationärer Energiespeicher in einem Mikrostromnetz; Energiespeicher für mobile Anwendungen; Niederlastenergiespeicher; Energiespeicher für Leichtelektrofahrzeuge wie z.B. Fahrräder oder Roller; Energiespeicher für Elektropersonenkraftwagen; Innenraumanwendung; und Außenraumanwendung.

Verschiedene Beispiele der Erfindung betreffen Techniken, um die Bestimmung eines Zustandswerts einer Batterie zu ermöglichen. Beispiele für Zustandswerte umfassen: Ladezustand, Alterungszustand oder Leistungsfähigkeit. Ein weiteres Beispiel betrifft Leistungsgrenzen der Batterie, beispielsweise eine augenblickliche, d.h., kurzfristige Leistungsgrenze (etwa auf einer Zeitskala von ca. 1 Sekunde oder kürzer) und/oder Leistungsgrenzen über einen längeren Zeitraum, d.h., z.B. mehrere 10 Sekunden oder Minuten. Ein weiteres Beispiel betrifft den Wärmeverlust durch Dissipation von elektrischer Energie.

Verschiedene Beispiele beruhen auf der Erkenntnis, dass solche und weitere Zustandswerte der Batterie bestimmt werden können basierend auf einer Widerstandsabschätzung für mindestens eine Batteriezelle der Batterie. Die Widerstandsabschätzung kann insbesondere eine Abschätzung des DC-Innenwiderstands der Batterie beschreiben. Z.B. könnte mittels der Widerstandsabschätzung ein Ersatzschaltkreismodell der Batterie parametriert werden.

Gemäß den verschiedenen hierin beschriebenen Beispielen ist es möglich, eine Datenstruktur zu erzeugen und zu befüllen, die Einträge beinhaltet, die indikativ für die Widerstandsabschätzung einer oder mehrerer Batteriezellen der Batterie sind. Basierend auf einer solchen Datenstruktur wäre es dann möglich, einen oder mehrere Zustandswerte der Batterie zu bestimmen.

Z.B. könnte die Datenstruktur in einer Datenbank gespeichert werden. Die Datenbank kann z.B. in einem Cloud-Speicher abgelegt sein. Z.B. kann auf die Datenstruktur von einem zentralen Server zugegriffen werden, der nicht ortsfest verbunden mit der Batterie ist.

Es wäre aber auch möglich, dass die Datenstruktur lokal gespeichert wird, d.h. zugeordnet zur jeweiligen Batterie. Z.B. könnte die Datenstruktur in einem Speicher eines Batterie-Managementsystems oder einer Steuereinheit gespeichert werden.

Dabei kann eine Datenstruktur Information für ein oder mehrere Batteriezellen einer jeweiligen Batterie beinhalten.

Insbesondere kann die Datenstruktur eine Vielzahl von Einträgen aufweisen, die mit unterschiedlichen Werten von zwei oder mehr Betriebsparametern der Batterie assoziiert sind. Beispiele für Betriebsparameter wären zum Beispiel: Temperatur; Ladungszustand; auf die Kapazität normierte Stromstärke (C-Rate); Entladungstiefe; Absolutwert der Stromstärke; etc. Das bedeutet also in anderen Worten, dass die Datenstruktur die Widerstandsabschätzung aufgelöst für mehrere Betriebsparameter der Batterie beschreiben kann. Je nachdem, wie viele Betriebsparameter berücksichtigt werden, kann die Datenstruktur eine unterschiedliche Dimensionalität aufweisen, z.B. in 2-D Array oder ein 3-D Array, wenn zwei oder drei Betriebsparameter berücksichtigt werden.

Es wäre in manchen Beispielen sogar möglich, dass der Betriebsparameter die Stromstärke umfasst, beispielsweise normiert auf die Kapazität (C-Rate). Dies beruht auf der Erkenntnis, dass der Widerstand auch eine Abhängigkeit von der Stromstärke selbst aufweisen kann. Insbesondere könnte ein Absolutwert der Stromstärke (d.h. die Magnitude) berücksichtigt werden.

Eine beispielhafte Datenstruktur ist nachfolgend in TAB. 1 wiedergegeben.

| SOC[%]/ Temperatur [°C] | -20 bis 0 | 0 bis 20 | 20 bis 40 |
|---|---|---|---|
| 0 bis 50 | [$R_{DC}$-Abfolge Rohdaten], [Zeitstempel], [Gewicht] Mittelwert StdAbweichung | [$R_{DC}$-Abfolge Rohdaten], [Zeitstempel], [Gewicht] Mittelwert StdAbweichung | [$R_{DC}$-Abfolge Rohdaten], [Zeitstempel], [Gewicht] Mittelwert StdAbweichung |
| 50 bis 100 | [$R_{DC}$-Abfolge Rohdaten], [Zeitstempel], [Gewicht] Mittelwert StdAbweichung | [$R_{DC}$-Abfolge Rohdaten], [Zeitstempel], [Gewicht] Mittelwert StdAbweichung | [$R_{DC}$-Abfolge Rohdaten], [Zeitstempel], [Gewicht] Mittelwert StdAbweichung |

TAB. 1: Beispiel für eine Datenstruktur, die insgesamt 2 × 3 Einträge aufweist, für die Betriebsparameter Ladungszustand (Reihen) und Temperatur (Spalten). Das bedeutet, dass die unterschiedlichen Einträge der Datenstruktur mit unterschiedlichen Werten für die beiden Betriebsparameter Ladungszustand und Temperatur assoziiert sind. Das heißt, es werden sog. "bins" für die verschiedenen Werte der Betriebsparameter vorgesehen. Als allgemeine Regel können mehr und/oder andere Betriebsparameter berücksichtigt werden. In dem Beispiel der TAB. 1 ist bestimmte Information im Zusammenhang mit den Widerstandsabschätzungen für ein oder mehrere Batteriezellen vorgesehen. Das ist beispielhafte Information und Informationsgehalt der Datenstruktur kann in den verschiedenen hierin beschriebenen Varianten variieren. Insbesondere können andere Betriebsparameter oder mehr Betriebsparameter berücksichtigt werden. Beispielsweise könnte der Widerstand aufgeschlüsselt nach SOC und C-Rate und optional Temperatur gespeichert werden. Ein anderes Beispiel für den Betriebsparameter betrifft die Magnitude (d.h. den Absolutwert) der Stromstärke, bei der die $R_{DC}$-Werte ermittelt wurden.

Im Beispiel der TAB. 1 wird eine Datenstruktur verwendet, die die Form einer zweidimensionalen Matrix aufweist. Das bedeutet in anderen Worten, dass der Widerstand für zwei unterschiedliche Betriebsparameter, im obigen Beispiel sind das der Ladungszustand und die Temperatur, bereitgestellt wird. Als allgemeine Regel wäre es aber denkbar, dass eine größere Anzahl von Betriebsparametern berücksichtigt wird. Beispielsweise könnte eine dreidimensionale Matrix verwendet werden (bzw. ein dreidimensionales Array), welche Einträge für die Betriebsparameter Ladungszustand, Temperatur und Absolutwert des Stroms aufweist. Insbesondere wurde festgestellt, dass eine Berücksichtigung des Absolutwerts des Stroms hilfreich sein kann, um beispielsweise den Alterungszustand mit einer höheren Genauigkeit zu bestimmen. Beispielsweise wurde festgestellt, dass je nach Batterietyp oder Zellcharakteristik signifikant unterschiedliche Stromstärken für das Laden oder Entladen verwendet werden und zusammen mit Variationen in den Stromstärken auch Änderungen im Zusammenhang mit dem Alterungszustand auftreten können. Beispielsweise können unterschiedliche Regime für den Absolutwert des Stroms für einen Batterietyp, der für eine schnelle Entladung optimiert ist, und für einen anderen Batterietyp, der für eine hohe Kapazität optimiert ist, beobachtet werden. Durch das Vorsehen einer entsprechenden Dimension der Datenstruktur (Absolutwert Stromstärke) kann dies bei der Ermittlung z.B. des Alterungszustands berücksichtigt werden.

Aus dem Beispiel der TAB. 1 ist ferner ersichtlich, dass jeder Eintrag der Datenstruktur insbesondere eine statistische Kenngröße einer Vielzahl von Widerstandsabschätzung für die zwei Betriebsparameter umfasst. Die statistische Kenngröße bezeichnet also eine Dimensionalitätsreduktion der Vielzahl von Widerstandsabschätzung. Durch die statistische Kenngröße kann eine Verteilung der Vielzahl von Widerstandsabschätzung charakterisiert werden. Im Beispiel der TAB. 1 sind das die statistischen Kenngrößen Mittelwert und Standardabweichung. Als allgemeine Regel können aber alternativ oder zusätzlich andere statistische Kenngrößen berücksichtigt werden, zum Beispiel Median, absolute Abweichung vom Median, usw.Indem die statistische Kenngröße bereits in der Datenstruktur vorgehalten wird, kann das nachfolgende Bestimmen eines Zustandswert der Batterie besonders einfach und zuverlässig und zügig erfolgen. Insbesondere kann die Auswertung der Vielzahl von Datenstrukturen vorgezogen werden, so dass eine nachfolgende Auswertungsanwendung bereits von der statistischen Auswertung profitieren kann.

Verschiedene Beispiele beruhen auf der Erkenntnis, dass Widerstandsabschätzungen, die auf Messdaten aus dem laufenden Betrieb der Batterie beruhen, häufig eine starke Abhängigkeit einer Abtastrate (engl. sampling rate) der Messdaten aufweisen. Beispielsweise kann eine Verteilung von Widerstandsabschätzungen in Abhängigkeit der Abtastrate variieren. Da oftmals die Abtastrate technologisch bedingt begrenzt ist, kann es im Rahmen der hierin beschriebenen Techniken durch die statistische Auswertung möglich sein, entsprechende Einflüsse zu reduzieren oder zu kompensieren.

Die Datenstruktur beinhaltet außerdem mehrere Widerstandsabschätzungen und zugehörige Zeitstempel. Diese sind in zwei Arrays hinterlegt. Die Zeitstempel können z.B. denjenigen Zeitpunkt bezeichnen, an dem entsprechende Messdaten - also Stromfluss und Spannung - gemessen wurden. Die Zeitstempel könnten noch denjenigen Zeitpunkt bezeichnen, an dem entsprechende Messdaten von einem Managementsystem der Batterie empfangen wurden. Die mehreren Widerstandsabschätzungen sind also die Rohdaten der statistischen Kenngröße.

Im Beispiel der TAB. 1 sind den Widerstandsabschätzungen außerdem auch noch Gewichte zugeordnet. Beispielsweise könnten die Gewichte als numerische Werte in einem vordefinierten Wertebereich, z.B. von 0 bis 1 angeordnet sein. Je größer oder kleiner das Gewicht, desto stärker oder schwächer kann dann die entsprechende Widerstandsabschätzung berücksichtigt werden, z.B. beim Ermitteln der statistischen Kenngröße oder in einer nachfolgenden Auswertung zur Bestimmung eines Zustandswerts der Batterie. Die Gewichte können basierend auf einer Filterung ermittelt werden. Z.B. könnte eine Filterung der Spannung-Strom-Wertepaare, aus denen die Widerstandsabsetzungen ermittelt werden, erfolgen, z.B. basierend auf einer Auswertung einer Änderung der Spannungskomponente und/oder der Stromkomponente der Strom-Spannung-Wertepaare. Z.B. könnten solche Gewichte verwendet werden, die eine stärkere Berücksichtigung bei einer nachfolgenden Verarbeitung (z.B. beim Ermitteln der statistischen Kenngröße oder in einer nachfolgenden Auswertung zur Bestimmung eines Zustandswerts der Batterie) bedingen, wenn die entsprechende Widerstandsabschätzung basierend auf einem Spannung-Strom-Wertepaar ermittelt wird, welches nach einer Relaxationsphase mit kleiner Stromkomponente über einen gewissen Zeitraum und/oder für eine bestimmte Anzahl von Spannung-Strom-Wertepaaren angeordnet ist.

In einem Beispiel wäre es denkbar, dass die Array-Einträge der Datenstruktur in einem rollierenden Schema geändert werden. Das bedeutet, dass immer eine vorgegebene Anzahl von Widerstandsabschätzungen in dem entsprechenden Array der Rohdaten vorgehalten wird. Z.B. könnte immer einer Anzahl von 1000 Widerstandsabschätzungen vorgehalten werden. Wird eine neue Widerstandsabschätzung verfügbar, so kann diese an einer aktuellen Position des Arrays eingefügt werden, und die letzte Position des Arrays kann gelöscht werden. D.h., die älteste Widerstandsabschätzung wird durch die neueste Widerstandsabschätzung ersetzt.

Indem die Rohdaten auch vorgehalten werden, ist es möglich, eine Detailanalyse der entsprechenden Verteilung im Rahmen der Bestimmung des Zustandswerts durchzuführen.

Außerdem kann die statistische Kenngröße angepasst werden, wenn weitere Widerstandsabschätzungen verfügbar werden. Dann kann nämlich die entsprechende statistische Auswertung für eine Vielzahl der Widerstandsabschätzungen durchgeführt werden, die die mehreren Widerstandsabschätzungen aus dem Array sowie die neu verfügbar werdende Widerstandsabschätzung umfasst. Dies kann unter Berücksichtigung von Gewichten erfolgen, wenn vorhanden.

Eine neue Widerstandsabschätzung wird bestimmt basierend auf einer Abfolge von mindestens zwei Spannung-Strom-Wertepaaren. Allgemein formuliert kann eine neue Widerstandsabschätzung bestimmt werden basierend auf Messwerten für elektrische Charakteristiken der entsprechenden ein oder mehreren Batteriezellen der Batterie. Insbesondere kann eine Abfolge von mindestens 2 Spannung-Strom-Wertepaaren erhalten werden und dann basierend auf dieser Abfolge die Widerstandsabschätzung bestimmt werden.

Die Abfolge von Spannungswerten ist: $U_k$, k=1, 2, ...

Die Abfolge von Stromwerten ist:: $I_k$, $k$ = 1,2, ...

Diesen Spannung-Strom-Wertepaaren sind Zeitstempel zugeordnet: $t_k$

Es ist dann möglich, die Widerstandsabschätzung zu bestimmen:

$$R_{DC} = \frac{\Delta U}{\Delta I}, \qquad\qquad (1)$$

wobei

$$\Delta U = U_k - U_{k-1} \text{ und } \Delta I = I_k - I_{k-1}.$$

In diesem Beispiel wird die Differenzspannung und wird der Differenzstrom jeweils basierend auf einem Paar von Messwerten für die Spannung bzw. den Strom bestimmt. Wenn aber eine Abfolge von mehr als zwei Strom-Spannung-Wertepaaren vorhanden ist, können bei einer entsprechenden Bestimmung der Differenzspannung und des Differenzstroms auch mehr als einzelne Paare von Messwerten berücksichtigt werden, z.B. indem erst beieinanderliegende Differenzspannungen und Differenzströme gemittelt werden.

In den verschiedenen Beispielen wäre es denkbar, dass die Spannungskomponente korrigiert wird, nämlich um den Wert einer Ruhespannung. Das bedeutet:

$$U_k \rightarrow U_k - OCV_k.$$

Dabei bezeichnet die Ruhespannung (auch als Leerlaufspannung bezeichnet; engl. open circuit voltage, OCV) diejenige Spannung, die zwischen den Klemmen der Batterie (Pluspol und Minuspol) anliegt, wenn die Klemmen offen sind (lastfrei), das heißt nicht miteinander (zum Beispiel über eine Last) verbunden sind. Das bedeutet, dass zwischen den Klemmen der Batterie kein Strom fließt.

Typischerweise ist es für Batterien im Feldbetrieb - die zum Beispiel in einem Elektrofahrzeug eingebaut sind oder allgemein einen Verbraucher versorgen - nicht oder nur eingeschränkt möglich, die Ruhespannung direkt zu messen. Dies liegt daran, dass es nicht oder nur selten vorkommt, dass die Batterie lastfrei ist. Die Ruhespannung ist also ein sog. versteckter Parameter der Batterie, der nicht direkt gemessen werden kann, aber aus anderen Größen abgeleitet werden kann.

Es sind Techniken bekannt, um die Ruhespannung einer Batterie in speziellen Kalibrationsphasen, manchmal als Check-up-Zyklen bezeichnet, zu bestimmen. Siehe zum Beispiel Petzl, Mathias, and Michael A. Danzer. "Advancements in OCV measurement and analysis for lithium-ion batteries." IEEE Transactions on energy conversion 28.3 (2013): 675-681.

Es ist möglich, unter Verwendung der folgenden Gleichung die Ruhespannung basierend auf einer Zeitreihe von Strom-Spannung-Wertepaaren zu bestimmen:

$$OCV(k) = U(k) - dR(k) \cdot I(k) = U(k) - \frac{dI(k)}{dU(k)} I(k).$$

Das bedeutet also, dass eine Abschätzung der Ruhespannung basierend auf dem differenziellen Widerstand bestimmt werden kann. Der differentielle Widerstand beschreibt allgemein die Änderung der Spannung in Bezug auf eine (differentiell kleine) Änderung des Stromflusses. Der differentielle Widerstand kann mit dem Stromfluss multipliziert werden und mit der gemessenen Spannung als Bezugswert addiert werden.

Um gleiche Vorzeichen für den differentiellen Widerstand bzw. die Änderung des Stromflusses zu erhalten, kann eine Filterung der Spannung-Strom-Wertepaare basierend auf der Änderung der Stromkomponente in Bezug auf ein vorgegebenes Schwankungsfenster - welches z.B. nur positive oder nur negative Stromflüsse berücksichtigt, für Laden oder Entladen - verwendet werden. Derart kann eine Entlade-Ruhespannung oder eine Lade-Ruhespannung bestimmt werden. Es ist insbesondere auch möglich, eine Hysterese der Ruhespannung zwischen einem Ladevorgang und einem Entladevorgang zu berücksichtigen.

In anderen Beispielen könnte ein rekurrentes neuronales Netzwerk dazu verwendet werden, die Abschätzung für die Ruhespannung zu bestimmen. In dem letztgenannten Fall könnte mittels herkömmlicher Techniken, zum Beispiel durch Coulomb-Zählen ein jeweils zugehöriger Ladungszustand bestimmt werden. Ein rekurrentes neuronales Netzwerk (RNN) kann als Eingabe einen mehrdimensionalen Merkmalsvektor empfangen, wobei unterschiedliche Kanäle mit unterschiedlichen Zeitpunkten assoziiert sind. Dies bedeutet, dass insbesondere Strom-Spannung-Wertepaare für mehrere Zeitpunkte der Zeitreihe als Eingabe an das RNN übergeben werden können. Allgemein kann ein RNN mehrere Schichten aufweisen, wobei auch Rückwärtsverbindungen von Neuronen einer Schicht zu Neuronen von ein oder mehreren vorangegangenen Schichten möglich sind. Direkte oder indirekte Rückkopplungen sind möglich. Das RNN kann zum Beispiel durch Verwendung von Trainingsdaten, die von Batterien gleichen Typs eines entsprechenden Ensembles erhalten werden, trainiert werden.

Techniken zum Bestimmen der Ruhespannung sind bekannt aus der deutschen Patentanmeldung 10 2021 105 784, deren entsprechender Offenbarungsgehalt hierin durch Querverweis übernommen wird.

Durch das Korrigieren basierend auf der Ruhespannung - beispielsweise insbesondere getrennt nach Lade-Ruhespannung und Entlade-Ruhespannung, die aufgrund einer Hysterese voneinander verschieden sein können -, kann eine besonders Genaue Widerstandsabschätzung erhalten werden, auch wenn z.B. während eines Entladevorgangs oder eines Ladevorgangs gemessen wird. Dadurch kann dann der Zustand der Batterie genauer geschätzt werden.

In den verschiedenen hierin beschriebenen Beispielen ist es möglich, eine Filterung vorzunehmen. Die Filterung kann z.B. auf Ebene der Spannung-Strom-Wertepaare erfolgen. Das bedeutet, es kann eine Vorfilterung erfolgen, bevor auf einen entsprechenden Eintrag in der Datenstruktur zugegriffen wird, in dem eine Vielzahl von Widerstandsabschätzungen hinterlegt ist (Vorfilterung). Eine solche Vorfilterung kann also eine Auswertung der Abfolge von mindestens zwei Spannung-Strom-Wertepaaren umfassen und dann könnte die entsprechende Widerstandsabschätzung entweder verworfen werden oder beibehalten werden und anschließend der Eintrag in der Datenstruktur geändert werden, je nach Ergebnis der Vorauswertung. Das bedeutet also, dass die Abfolge der Stromkomponente und/oder der Spannungskomponente der Strom-Spannung-Wertepaare entlang der Strom-Spannung-Wertepaare (d.h. die Änderung zwischen verschiedenen Strom-Spannung-Wertepaaren) berücksichtigt werden kann. Es könnten auch Gewichte zugeordnet werden, welche mit der Genauigkeit der Widerstandsabschätzung korrelieren; derart können Widerstandsabschätzungen mit höherer Genauigkeit bei der Ermittlung des Zustandswerts der Batterie stärker berücksichtigt werden, als Widerstandsabschätzungen mit geringer Genauigkeit. Die Vorfilterung kann einen Plausibilitäts-Check darstellen. Z.B. könnte überprüft werden, ob die Änderung der Spannungskomponente und der Stromkomponente des Spannung-Strom-Wertepaars zueinander passt, also z.B. einen Ladungsvorgang (zweimal positives Vorzeichen) oder einen Entladungsvorgang (zweimal negatives Vorzeichen) beschreibt. Es könnte aber auch eine statistische Filterung erfolgen, nämlich auf Grundlage der Vielzahl von Widerstandsabschätzungen, welche die neue Widerstandsabschätzung und mehrere Widerstandsabschätzungen aus der Datenstruktur umfasst. Hier könnte die Vielzahl von Widerstandsabschätzungen gefiltert werden und dann die statistische Kenngröße auf Grundlage der entsprechenden gefilterten Vielzahl von Widerstandsabschätzungen ermittelt werden, in dem eine entsprechende statistische Auswertung durchgeführt wird. Z.B. könnten Ausreißer entfernt werden oder Extremwerte - d.h., z.B. besonders geringe oder besonders große Widerstandsabschätzungen - aus der Vielzahl von Widerstandsabschätzungen entfernt werden. Beispielsweise können Ausreißer durch asynchrone Messpunkte für Spannung und Strom entstehen. Das ist ein messtechnisch bedingtes Artefakt.

Beispielsweise könnte eine Vorfilterung der Spannung-Strom-Wertepaare in Abhängigkeit der Stromkomponente erfolgen. Z.B. könnte berücksichtigt werden, ob die Stromkomponente Schwankungen innerhalb eines vorgegebenen Schwankungsfensters aufweist. Solange die Stromkomponente innerhalb des vorgegebenen Schwankungsfensters variiert, können die entsprechenden Spannung-Strom-Wertepaare beibehalten werden. Beispielsweise könnte der Schwankungsfenster alle positiven oder alle negativen Stromflüsse beinhalten (das kann insbesondere hilfreich sein, wenn eine Korrektur der Spannungskomponente basierend auf einer Abschätzung der Ruhespannung erfolgen soll). Das Schwankungsfenster könnte z.B. auch um einen bestimmten positiven Stromflusswert angeordnet sein, z.B. um ein kontinuierliches Laden der Batterie mit einem bestimmten Stromfluss zu erfassen.

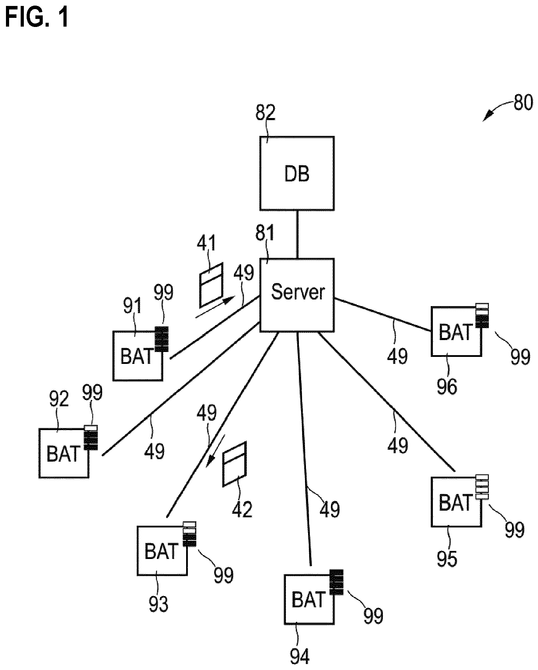

FIG. 1 illustriert Aspekte im Zusammenhang mit einem System 80. Das System 80 umfasst einen Server 81, der mit einer Datenbank 82 verbunden ist. Außerdem umfasst das System 80 Kommunikationsverbindungen 49 zwischen dem Server 81 und jeder von mehreren Batterien 91-96. Die Kommunikationsverbindungen 49 könnten z.B. über ein Mobilfunknetzwerk implementiert werden. Beispielsweise können die Batterien 91-96 ein Ensemble bilden, d.h., alle vom gleichen Typ sein.

In FIG. 1 ist beispielhaft illustriert, dass die Batterien 91-96 über die Kommunikationsverbindungen 49 Daten 41 an den Server 81 senden können. Beispielsweise wäre es möglich, dass die Daten 41 indikativ sind für eine Abfolge von Spannung-Strom-Wertepaare von einer oder mehreren Batteriezellen der Batterien 91-96. Es wäre aber auch denkbar, dass eine Widerstandsabschätzung basierend auf einer Abfolge von Spannung-Strom-Wertepaaren bereits in einem Managementsystem durchgeführt wird, das lokal den jeweiligen Batterien 91-96 zugeordnet ist. Dann könnten die Daten 41 bereits die Widerstandsabschätzung beinhalten.

In FIG. 1 ist auch beispielhaft illustriert, dass der Server 81 über die Kommunikationsverbindungen 49 Steuerdaten 42 an die Batterien 91-96 senden kann. Beispielsweise wäre es möglich, dass die Steuerdaten 42 eine oder mehrere Betriebsgrenzen für den zukünftigen Betrieb der jeweiligen Batterie 91-96 indizieren. Z.B. könnten die Steuerdaten einen oder mehrere Steuerparameter für ein Thermomanagement der jeweiligen Batterie 91-96 und/oder ein Lademanagement der jeweiligen Batterie 91-96 indizieren. Durch Verwendung der Steuerdaten 42 kann der Server 81 also den Betrieb der Batterien 91-96 beeinflussen bzw. steuern. Dies könnte z.B. basieren auf einem Zustandswert 99, der vom Server 81 für die jeweilige Batterie ermittelt wird.

In FIG. 1 ist für jede der Batterien 91-96 schematisch ein Zustandswert 99 illustriert. Beispiele für Zustandswerte sind z.B. Alterungszustand, thermische Verlustleistung der jeweiligen Batterie 91-96, usw.

Nachfolgend werden Technik beschrieben, wie ein solcher Zustandswert 99 für die verschiedenen Batterien 91-96 basierend auf einer Widerstandsabschätzung der verschiedenen Batterien bestimmt werden kann. Dazu kann in der Datenbank 82 eine Datenstruktur - beispielsweise eine Datenstruktur gemäß TAB. 1 - hinterlegt sein. In der Datenstruktur kann jeweils eine statistische Kenngröße einer Vielzahl von Widerstandsabschätzungen, aufgelöst für verschiedene Werte von mindestens zwei Betriebsparameter der jeweiligen Batterie 91-96, hinterlegt sein. Diese statistische Kenngröße kann dazu verwendet werden, um den Zustandswert 99 der jeweiligen Batterie 91-96 zu bestimmen.

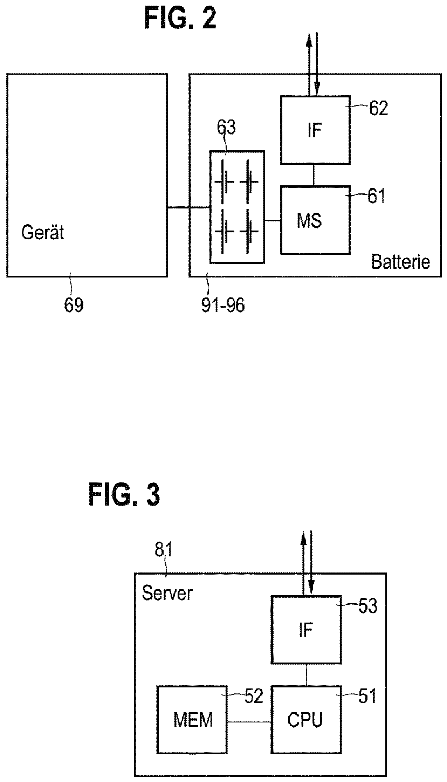

FIG. 2 illustriert Aspekte im Zusammenhang mit den Batterien 91-96. Die Batterien 91-96 sind mit einem jeweiligen Gerät 69 gekoppelt. Dieses Gerät — z.B. ein Elektromotor - wird durch elektrische Energie aus der jeweiligen Batterie 91-96 getrieben. Es stellt also eine elektrische Last dar.

Die Batterien 91-96 umfassen bzw. sind assoziiert mit einem oder mehreren Managementsystemen 61, z.B. ein BMS oder eine andere Steuerlogik wie eine on-boardunit im Falle eines Fahrzeugs. Das Managementsystem 61 kann z.B. durch Software auf einem CPU implementiert sein. Alternativ oder zusätzlich könnte z.B. ein Applikationsspezifischer Schaltkreis (ASIC) oder ein Feldprogrammierbares gated array (FPGA) verwendet werden. Die Batterien 91-96 könnten z.B. über ein Bussystem mit dem Managementsystem 61 kommunizieren. Die Batterien 91-96 umfassen auch eine Kommunikationsschnittstelle 62. Das Managementsystem 61 kann über die Kommunikationsschnittstelle 62 eine Kommunikationsverbindung 49 mit dem Server 81 aufbauen.

Während in FIG. 2 das Managementsystem 61 separat von den Batterien 91-96 gezeichnet ist, wäre es in anderen Beispielen auch möglich, dass das Managementsystem 61 Teil der Batterien 91-96 ist.

Außerdem umfassen die Batterien 91-96 einen oder mehrere Batterieblöcke 63. Jeder Batterieblock 63 umfasst typischerweise eine Anzahl von parallel geschalteten und/oder seriell geschalteten Batteriezellen. Dort kann elektrische Energie gespeichert werden.

Typischerweise kann das Managementsystem 61 auf einen oder mehrere Sensoren in einem oder mehreren Batterieblöcken 63 zurückgreifen. Die Sensoren können z.B. elektrische Kenngrößen der jeweiligen Batterie messen und entsprechende Messwerte bereitstellen, etwa den Stromfluss und/oder die Spannung in zumindest einigen der Batteriezellen. Die Sensoren können alternativ oder zusätzlich auch andere Betriebsparameter im Zusammenhang mit zumindest einigen der Batteriezellen messen, beispielsweise Temperatur, Volumen, Druck, Tiefenentladung, Ladungszustand, etc. Das Managementsystem 61 kann dann eingerichtet sein, um ein oder mehrere solcher Messwerte von Sensoren in Form von Daten 41 an den Server 81 zu senden. Das Managementsystem 61 könnte auch eingerichtet sein, um basierend auf Spannung-Strom-Wertepaaren Widerstandsabschätzungen für die jeweilige Batterie 91-96 zu bestimmen und im Zusammenhang mit den Daten 41 einen Server 81 zu senden.

FIG. 3 illustriert Aspekte im Zusammenhang mit dem Server 81. Der Server 81 umfasst einen Prozessor 51 sowie einen Speicher 52. Der Speicher 52 kann ein flüchtiges Speicherelement und/oder ein nicht-flüchtiges Speicherelement umfassen. Außerdem umfasst der Server 81 auch eine Kommunikationsschnittstelle 53. Der Prozessor 51 kann über die Kommunikationsschnittstelle 53 eine Kommunikationsverbindung 49 mit jeder der Batterien 91-96 und der Datenbank 82 aufbauen.

Z.B. kann Programmcode im Speicher 52 gespeichert sein und vom Prozessor 51 geladen werden. Der Prozessor 51 kann dann den Programmcode ausführen. Das Ausführen des Programmcodes bewirkt, dass der Prozessor 51 einen oder mehrere der folgenden Prozesse ausführt, wie sie im Zusammenhang mit den verschiedenen Beispielen hierin im Detail beschrieben sind: Erhalten einer Widerstandsabschätzung einer Widerstandsabschätzung basierend auf einer Abfolge von mindestens zwei Spannung-Strom-Wertepaaren, z.B. durch Anwenden von Gl. (1) oder durch Empfangen von Messdaten 41, die bereits indikativ für die Widerstandsabschätzung sind; Aktualisieren einer Datenstruktur mit einer Vielzahl von Einträgen, wobei jeder Eintrag der Vielzahl von Einträgen zumindest eine statistische Kenngröße für eine jeweilige Vielzahl von Widerstandsabschätzungen für entsprechende Werte von mindestens zwei Betriebsparametern der jeweiligen Batterie umfasst; Filtern der Vielzahl von Widerstandsabschätzungen; Durchführen einer Vorauswertung der Abfolge von mindestens zwei Spannung-Strom-Wertepaaren; usw.

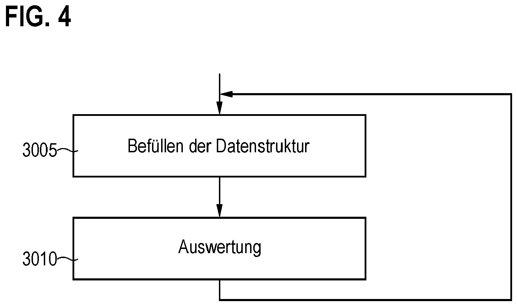

FIG. 4 ist ein Flussdiagramm eines beispielhaften Verfahrens. Beispielsweise kann das Verfahren zumindest von einem Server, etwa dem Server 81, ausgeführt werden. Insbesondere könnte das Verfahren z.B. von dem Prozessor 51 ausgeführt werden, basierend auf Programmcode, die der Prozessor 51 aus dem Speicher 52 lädt und ausführt. Es wäre aber auch denkbar, dass zumindest Teile des Verfahrens von einem Managementsystem - z.B. Managementsystem 61 — der jeweiligen Batterie ausgeführt werden.

In Box 3005 erfolgt das Befüllen einer Datenstruktur. Beispielsweise kann die Datenstruktur in einer verbundenen Datenbank - etwa der Datenbank 82 - abgelegt sein. Box 3005 könnte z.B. gemischt auf einem Server und einem Managementsystem einer Batterie ausgeführt werden.

Die Datenstruktur wird mit Information befüllt, die indikativ für einen Widerstand einer jeweils zugehörigen Batterie ist. Insbesondere kann Information zum DC-Widerstand in der Datenstruktur hinterlegt werden. Dabei kann entsprechende Information aufgelöst für unterschiedliche Werte von zwei oder mehr Betriebsparameter der Batterie vorgehalten werden. Die Datenstruktur kann entsprechende "bins" beinhalten (d.h., die Zellen der TAB. 1). Das bedeutet, dass der Widerstand der Batterie eine Abhängigkeit von diesen Betriebsparametern der Batterie aufweisen kann und diese Abhängigkeit in der Datenstruktur erfasst werden kann.

Insbesondere kann das Befüllen der Datenstruktur in Box 3005 das Ändern von Einträgen in der Datenstruktur umfassen. Die verschiedenen Einträge sind dabei mit bestimmten Werten für die mindestens zwei Betriebsparameter der Batterie assoziiert.

Dabei können z.B. statistische Kenngrößen für eine Vielzahl von Widerstandsabschätzungen bei entsprechenden Werten der mindestens zwei Betriebsparameter geändert werden. Dies kann unter Berücksichtigung von Gewichten erfolgen, sofern vorhanden. Alternativ oder zusätzlich könnte auch ein Array für eine Vielzahl von Widerstandsabschätzungen geändert werden, z.B. indem in das Array eine neue Widerstandsabschätzung für einen aktuellen Zeitpunkt hinzugefügt wird und optional ein alter Eintrag des Arrays entfernt wird.

Anschließend erfolgt in der optionalen Box 3010 einer Auswertung der Datenstruktur. Das bedeutet, dass ein Zustandswert der jeweiligen Batterie bestimmt werden kann, basierend auf der Information zum Widerstand der Batterie (vgl. FIG. 1, Zustandswert 99). Der Betrieb der jeweiligen Batterie 91-96 könnte dann basierend auf dem Zustandswert gesteuert werden, z.B. mit Steuerdaten 42.

Wenn der Datenstruktur auch Gewichte vorhanden sind, die unterschiedlichen Widerstandsabschätzungen zugeordnet sind, so wäre es denkbar, bei der Bestimmung des Zustandswerts die Gewichte zu berücksichtigen. Z.B. könnte ein entsprechender Algorithmus solche Widerstandsabschätzungen weniger stark berücksichtigen, die mit Gewichten assoziiert sind, die ein geringes Konfidenzniveau der entsprechenden Widerstandsabschätzung indizieren.

Nachfolgend werden insbesondere Techniken im Zusammenhang mit Box 3005 beschrieben. Die hierin beschriebenen Techniken ermöglichen es, die Datenstruktur mit signifikanter Information zum Widerstand der jeweiligen Batterie zu befüllen. Das bedeutet, dass Messartefakte oder andere Störeinflüsse, etwa Rauschen usw., bereits beim Befüllen der Datenstruktur erkannt und unterdrückt werden können. Dadurch ist es dann möglich, bei der Auswertungen Box 3010 den Zustandswert Batterie besonders genau bzw. zuverlässig zu bestimmen.

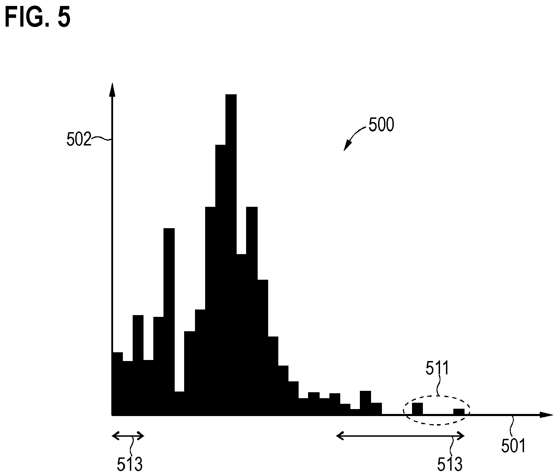

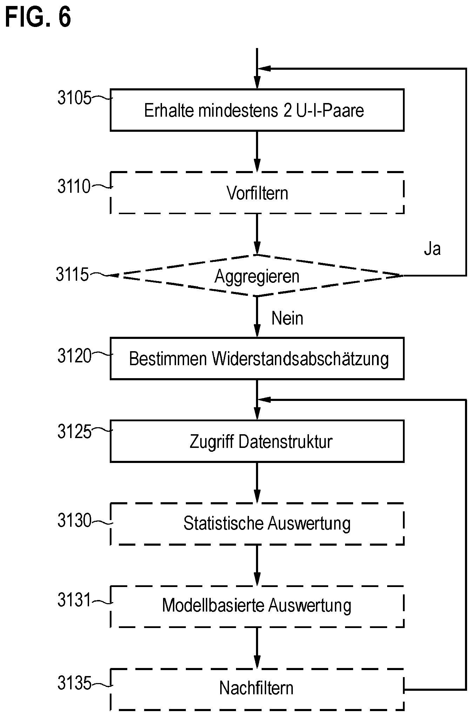

Dabei beruhen verschiedene Techniken auf der Erkenntnis, dass typischerweise eine Vielzahl von Widerstandsabschätzungen für eine bestimmte Batterie bei bestimmten Werten für zwei oder mehr Betriebsparameter einer Streuung unterliegen. Eine entsprechende Verteilung 500 von Widerstandsabschätzungen 501 ist in FIG. 5 dargestellt. In FIG. 5 ist die Häufigkeit 502 der verschiedenen Widerstandsabschätzungen 501 angegeben. Aus FIG. 5 ist ersichtlich, dass die verschiedenen Widerstandsabschätzungen 501 für die bestimmten Werte der Betriebsparameter (zum Beispiel 0 °C bis 20 °C und 20 % SOC bis 40 % SOC) mit einer unterschiedlichen Häufigkeit 502 vorkommen. Nachfolgend wird im Zusammenhang mit FIG. 6 beschrieben, wie trotz einer solchen Verteilung der Vielzahl von Widerstandsabschätzungen die Datenstruktur zuverlässig mit signifikanter Information befüllt werden kann.

FIG. 6 ist ein Flussdiagramm eines beispielhaften Verfahrens. Das Verfahren aus FIG. 6 kann insbesondere Box 3005 aus FIG. 4 implementieren. Das Verfahren aus FIG. 6 kann von einem Server, beispielsweise dem Server 81 ausgeführt werden. Zum Beispiel könnte der Prozessor 51 Programmcode aus dem Speicher 52 laden und diesen ausführen, um das Verfahren aus FIG. 6 zu implementieren. Das Verfahren aus FIG. 6 könnte aber zumindest teilweise auch von einem Batterie-Managementsystem ausgeführt werden, beispielsweise von den Managementsystem 61, wobei dann insbesondere auch eine lokale Speicherung der entsprechenden Datenstruktur hilfreich sein kann.

Optionale Boxen sind mit gestrichelten Linien dargestellt.

In Box 3105 wird einer Abfolge von mindestens zwei Spannung-Strom-Wertepaaren erhalten, die bei ein oder mehreren Batteriezellen gemessen wurden. Zum Beispiel könnte die Abfolge in Form der Daten 41 (vergleiche FIG. 1) erhalten werden. Diese sind assoziiert mit bestimmten Werten für mindestens zwei Betriebsparameter dieser ein oder mehreren Batteriezellen.

Es wäre denkbar, dass zusammen mit der Abfolge der mindestens zwei Spannung-Strom-Wertepaare auch eine Information betreffend die Werte für die mindestens zwei Betriebsparameter erhalten wird. Entsprechende Information kann im Rahmen der Daten 41 erhalten werten.

Dann ist es in Box 3110 möglich, eine Vorfilterung durchzuführen. Dazu kann eine Auswertung der Abfolge der mindestens zwei Spannung-Strom-Wertepaare erfolgen und dann eine entsprechende Widerstandsabschätzung, die auf dieser Abfolge basiert, verworfen werden, d.h., nicht für das Ablegen in der Datenstruktur vorgesehen werden.

Bei der Vorfilterung könnte z.B. im Rahmen der entsprechenden Auswertung die Änderungen der Spannungskomponente und/oder der Stromkomponente der Abfolge von Spannung-Strom-Wertepaare berücksichtigt werden und dann kann unter Berücksichtigung dieser Änderungen, z.B. in Abhängigkeit des Vorzeichens, das Verwerfen erfolgen oder nicht. Es sind auch andere Arten von Auswertungen denkbar. Beispielsweise könnte überprüft werden, ob ein Zeitabstand zwischen zwei Spannung-Strom-Wertepaaren der Abfolge groß oder klein genug ist. Schwellenwertvergleiche können ausgeführt werden. Es könnten auch die Absolutwerte der Stromkomponente und/oder der Spannungskomponente mit bestimmten Vorgabekriterien verglichen werden.

Im Rahmen von Box 3110 kann also insbesondere ein Kontext eines Strom-Spannung-Wertepaares berücksichtigt werden, in der Abfolge der Strom-Spannung-Wertepaare. Beispielsweise könnte überprüft werden, ob vor einem bestimmten Strom-Spannung-Wertepaar eine genügend lange Ruhephase vorlag, d. h. ob vor einem bestimmten Strom-Spannung-Wertepaar die Stromkomponente der vorhergehenden Strom-Spannung-Wertepaare (z.B. einer vordefinierten Anzahl oder einer Anzahl, die einen vordefinierten Zeitraum abdeckt) unterhalb eines vorgegebenen Schwellenwertes lag. Beispielsweise könnte lediglich solche Strom-Spannung-Wertepaare beibehalten werden, bei denen eine genügend lange Ruhephase vorangegangen ist. Strom-Spannung-Werte Paare, bei denen keine genügend lange Ruhephase vorangegangen ist, können verworfen werden.

Dabei ist eine binäre Filterung wie beschrieben (d. h. entweder Beibehalten eines Strom-Spannung-Wertepaares oder Löschen eines Strom-Spannung-Wertepaares) lediglich ein Beispiel für eine mögliche Implementierung. Die Filterung könnte auch Gewichte zuweisen, sodass in Abhängigkeit von den Gewichten Widerstandswerte bei der weiteren Datenverarbeitung stärker oder weniger stark berücksichtigt werden. Insbesondere können die Gewichte auch in der Datenstruktur hinterlegt werden. Z.B. wäre es denkbar, dass solche Strom-Spannung-Wertepaare ohne vorangegangene Relaxationsphase weniger stark gewichtet werden, weil der nachfolgenden Datenverarbeitung, z.B. zum Bestimmen des Alterungszustands oder bei Ermitteln einer statistischen Kenngröße. Die Gewichte könnten auch kontinuierlich vergeben werden, je nach Länge der Relaxationsphase.

Optional wäre es in Box 3115 möglich, eine Aggregation von Information vor einem Zugriff auf die Datenstruktur durchzuführen. Dabei können z.B. Spannung-Strom-Wertepaare durch mehrfaches Ausführen von Box 3105 gesammelt werden und zwischengespeichert werden, bevor ein Zugriff auf die Datenstruktur erfolgt. Es wäre aber auch denkbar, dass die Spannung-Strom-Wertepaare in Widerstandsabschätzungen umgerechnet werden (d.h., Box 3120 wird vorgezogen) und dann diese Widerstandsabschätzungen aggregiert werden.

Eine Aggregation kann z.B. so lange erfolgen, bis ein bestimmtes Kriterium erfüllt ist. Z.B könnte das Kriterium in Abhängigkeit von einem Zeitplan definiert sein. Z.B. wäre es denkbar, dass der Zeitplan eine Häufigkeit von Zugriffen auf die Datenstruktur spezifiziert. Derart kann insbesondere in Cloud-basierten Datenbanken, in denen die Datenstruktur abgespeichert wird, vermieden werden, dass zu häufig auf die Datenstruktur zugegriffen werden muss, was Leistungseinbußen mit sich bringen könnte.

In Box 3120 wird dann eine Widerstandsabschätzung basierend auf der oder den Abfolgen von Spannung-Strom-Wertepaaren aus Box 3105 durchgeführt. Vgl. Gl. (1). Insbesondere kann eine Änderung des Stromflusses mit einer Änderung der Spannung zwischen zwei aufeinanderfolgenden Spannung-Strom-Wertepaaren berücksichtigt werden. Die Widerstandsabschätzung aus Box 3120 kann in manchen Beispielen auch vor der Aggregation in Box 3115 erfolgen.

Dann erfolgt ein Zugriff auf die Datenstruktur in Box 3125. Insbesondere wird basierend auf der Widerstandsabschätzung aus Box 3120 ein Eintrag in der Datenstruktur geändert, der mit denselben Werten für die mindestens zwei Betriebsparameter assoziiert ist, mit denen auch die Abfolge der Spannung-Strom-Wertepaare aus Box 3105 assoziiert ist. Z.B wäre es möglich, dass die Widerstandsabschätzung aus Box 3120 in Box 3125 zur Datenstruktur hinzugefügt wird. Beispielsweise könnte die Vielzahl von Widerstandsabschätzungen in der Datenstruktur gelistet werden. Dann könnte an einer ersten Position eines entsprechenden Arrays die Widerstandsabschätzung aus Box 3120 hinzugefügt werden und beispielsweise die letzte Position des Arrays gelöscht werden, um die Arraylänge nicht zu verändern. Das bedeutet also, dass die älteste Widerstandsabschätzung ersetzt wird durch die neu bestimmte Widerstandsabschätzung aus Block 3120. Es kann auch ein Array von zugehörigen Zeitstempeln vorliegen. Alternativ könnte auch eine Interpolation auf ein vorgegebenes Zeitschema erfolgen.

In Box 3130 kann eine Vielzahl von Widerstandsabschätzungen bestimmt werden, basierend auf Widerstandsabschätzungen, die bereits in der Datenstruktur vorhanden sind und dass diese in Box 3125 ausgelesen werden können, sowie basierend auf der neuen Widerstandsabschätzung aus Box 3120. In Box 3130 kann dann eine statistische Auswertung dieser Vielzahl von Widerstandsabschätzungen erfolgen, um derart eine statistische Kenngröße für die Vielzahl von Widerstandsabschätzungen zu erhalten. Dabei können Gewichte berücksichtigt werden, die den Widerstandsabschätzungen der Vielzahl von Widerstandsabschätzungen zugeordnet sind. Die statistische Kenngröße könnte z.B. einen Mittelwert und/oder eine Standardabweichung und/oder einen Median, etc. bezeichnen. Es könnte - wenn Gewichte vorhanden sind, vgl. TAB. 1 - auch ein gewichteter Mittelwert bestimmt werden. Die statistische Kenngröße könnte dann wiederum in einem weiteren Zugriff auf die Datenstruktur in einer weiteren Iteration von Box 3125 im entsprechenden Eintrag der Datenstruktur abgelegt werden.

Optional könnte in Box 3135 auch eine Nachfilterung erfolgen, basierend auf der Vielzahl von Widerstandsabschätzungen, also nach dem Zugriff auf die Datenstruktur 3125, durch den eine Historie der Widerstandsabschätzungen erhalten wird (und nicht bloß basierend auf der neu in Box 3105 erhaltenen Information, wie im Zusammenhang mit Box 3110 beschrieben).

Eine solche Filterung in Box 3135 kann z.B. Ausreißer aus der Vielzahl von Widerstandsabschätzungen betreffen. Das bedeutet, dass die Ausreißer entfernt werden können. Es wäre aber auch denkbar, dass die Datenstruktur entsprechende Gewichte umfasst, sodass Ausreißer weniger stark berücksichtigt werden. Beispielsweise sind solche Ausreißer 511 in FIG. 5 illustriert. Es gibt unterschiedliche Möglichkeiten, Ausreißer 511 zu definieren. Beispielsweise können Ausreißer als solche Widerstandsabschätzungen 501 definiert werden, die von einem kontinuierlichen Bereich der Verteilung 500 von Widerstandsabschätzungen getrennt sind. Die Filterung könnte auch Extremwerte aus der Vielzahl von Widerstandsabschätzungen entfernen. Beispielsweise könnte eine Anzahl N der größten und/oder/der kleinsten Widerstandsabschätzungen entfernt werden. Eine entsprechende Menge 513 ist in FIG. 5 illustriert.

In FIG. 6 ist dargestellt, dass in Box 3130 eine statistische Auswertung zum Ermitteln der statistischen Kenngröße erfolgen kann. Das ist aber nur ein Beispiel. In manchen Beispielen wäre es alternativ oder zusätzlich auch denkbar, dass eine modellbasierte Auswertung erfolgt, wie in FIG. 6 im Zusammenhang mit Box 3131 dargestellt. Die Modellauswertung kann basierend auf der Vielzahl von Widerstandsabschätzungen einen modellbasierten Vorhersagewert für den Widerstand der entsprechenden einen oder mehreren Batteriezellen bestimmen. Dabei gibt es als allgemeine Regel unterschiedliche Varianten, um ein entsprechendes Modell für die modellbasierte Auswertung zu bestimmen.

Z.B. könnte das Modell maschinengelerntes sein. Z.B. könnte ein künstliches neuronales Netzwerk verwendet werden. Dabei könnte z.B. an einen Testfahrzeug die entsprechende Verteilung der Vielzahl von Widerstandswerten während des Betriebs gemessen werden und mit geeigneten labortechnisch vermittelten Messwerten für den Widerstand der Batterie als a-priori-Wissen verknüpft werden und basierend darauf das künstliche neuronale Netzwerk trainiert werden. Es könnte z.B. auch ein Kalman-Filter verwendet werden, der die Vielzahl von Widerstandsabschätzungen filtert. Derart kann insbesondere für Batterie-Typ-spezifisch trainierte künstliche neuronale Netzwerke eine hohe Genauigkeit für einen modellbasierten Vorhersagewert erzielt werden. Dieser modellbasierte Vorhersagewert kann z.B. eine höhere Genauigkeit aufweisen, als ein Median oder statistische Auswertung.

Zusammenfassend wurden voranstehend Techniken beschrieben, welche es ermöglichen, Informationen zum Widerstand einer oder mehrerer Batteriezellen robust zu erfassen und abzuspeichern. Insbesondere können Messfehler in Spannung-Strom-Wertepaaren reduziert oder kompensiert werden, beispielsweise Rauschen oder Zeit-Jitter. Z.B. können Ausreißer der Widerstandsabschätzung erkannt werden.

Selbstverständlich können die Merkmale der vorab beschriebenen Ausführungsformen und Aspekte der Erfindung miteinander kombiniert werden. Insbesondere können die Merkmale nicht nur in den beschriebenen Kombinationen, sondern auch in anderen Kombinationen oder für sich genommen verwendet werden, ohne das Gebiet der Erfindung zu verlassen.

Beispielsweise wurden voranstehend Aspekte beschrieben, bei denen die Einträge in der Datenstruktur eine statistische Kenngrößen einer Vielzahl von Widerstandsabschätzungen umfassen. In anderen Beispielen wäre es denkbar, dass die Einträge in der Datenstruktur - alternativ oder zusätzlich zur statistischen Kenngrößen - einen modellbasierten Vorhersagewert für den Widerstand der Batterie umfassen.

**Patentansprüche**

**1.** Verfahren, welches umfasst:

- Erhalten (3105, 3120) einer Widerstandsabschätzung basierend auf einer Abfolge von mindestens zwei Spannung-Strom-Wertepaaren mindestens einer Batteriezelle einer Batterie (91-96), wobei die Abfolge der mindestens zwei Spannung-Strom-Wertepaare assoziiert ist mit bestimmten Werten für mindestens zwei Betriebsparameter der mindestens einen Batteriezelle der Batterie,
- basierend auf der Widerstandsabschätzung, Ändern (3125) eines Eintrags in einer Datenstruktur, der mit den bestimmten Werten für die mindestens zwei Betriebsparameter assoziiert ist

wobei der Eintrag zumindest eine statistische Kenngröße einer Vielzahl von Widerstandsabschätzungen für die bestimmten Werte der mindestens zwei Betriebsparameter umfasst, wobei die Vielzahl von Widerstandsabschätzungen die Widerstandsabschätzung und mehrere weitere Widerstandsabschätzungen für die bestimmten Werte der mindestens zwei Betriebsparameter umfasst.

2. Verfahren nach Anspruch 1, wobei das Verfahren weiterhin umfasst:

- Filtern der Vielzahl von Widerstandsabschätzungen, um eine gefilterte Vielzahl von Widerstandsabschätzungen zu erhalten, und
- Durchführen einer statistischen Auswertung der gefilterten Vielzahl von Widerstandsabschätzungen zum Erhalten der statistischen Kenngröße

3. Verfahren nach Anspruch 2,
wobei das Filtern Ausreißer aus der Vielzahl von Widerstandsabschätzungen betrifft.

4. Verfahren nach Anspruch 2 oder 3,
wobei die statistische Auswertung Extremwerte aus der Vielzahl von Widerstandsabschätzungen betrifft.

5. Verfahren nach einem der voranstehenden Ansprüche, wobei das Verfahren weiterhin umfasst:

- Filtern der Spannung-Strom-Wertepaare der Abfolge von mindestens zwei Spannung-Strom-Wertepaaren basierend auf einer Änderung der Spannungskomponente und/oder einer Stromkomponente der mindestens zwei Spannung-Strom-Wertepaare entlang der mindestens zwei Spannung-Strom-Wertepaare.

6. Verfahren nach Anspruch 5,
wobei das Filtern der Spannung-Strom-Wertepaare basierend auf einer Änderung der Stromkomponente in Bezug auf ein vorgegebenes Schwankungsfenster erfolgt.

7. Verfahren nach einem der Ansprüche 2 bis 6, wobei das Verfahren weiterhin umfasst:

- Bestimmen eines Gewichts für die Widerstandsabschätzung basierend auf dem Filtern, und
- Hinterlegen des Gewichts in der Datenstruktur zusammen mit der Widerstandsabschätzung.

8. Verfahren nach einem der voranstehenden Ansprüche, wobei das Verfahren weiterhin umfasst:

- Korrigieren einer Spannungskomponente der mindestens zwei Spannung-Strom-Wertepaaren basierend auf einer Abschätzung für die Ruhespannung der mindestens einen Batteriezelle der Batterie (91-96).

9. Verfahren nach einem der voranstehenden Ansprüche,

wobei der Eintrag ferner die Vielzahl von Widerstandsabschätzungen und assoziierte Zeitstempel umfasst, der Eintrag geändert wird, indem eine älteste Widerstandsabschätzung der Vielzahl von Widerstandsabschätzungen ersetzt wird durch die Widerstandsabschätzung.

10. Verfahren nach einem der voranstehenden Ansprüche, das weiterhin umfasst:

- Durchführen einer Auswertung der Abfolge von mindestens zwei Spannung-Strom-Wertepaaren, und
- in Abhängigkeit von einem Ergebnis der Auswertung, wahlweise Verwerfen der Widerstandsabschätzung oder der Abfolge von mindestens zwei Spannung-Strom-Wertepaare vor dem Ändern des Eintrags in der Datenstruktur.

**11.** Verfahren nach einem der voranstehenden Ansprüche,
wobei die Auswertung eine Änderung von zumindest einem der Spannungskomponente der mindestens zwei Spannung-Strom-Wertepaare oder einer Stromkomponente der mindestens zwei Spannung-Strom-Wertepaare umfasst.

**12.** Verfahren nach einem der voranstehenden Ansprüche, das weiterhin umfasst:

- Durchführen einer modellbasierten Auswertung der Vielzahl von Widerstandsabschätzungen, zum Erhalten eines modellbasierten Vorhersagewerts,

wobei der Eintrag den modellbasierten Vorhersagewert umfasst.

**13.** Verfahren nach einem der voranstehenden Ansprüche, das weiterhin umfasst:

- vor dem Bestimmen der Widerstandsabschätzung, Aggregieren einer Anzahl von Spannung-Strom-Wertepaare der Abfolge von mindestens zwei Spannung-Strom-Wertepaare oder Aggregieren einer Anzahl von Widerstandsabschätzungen.

**14.** Gerät (81), das einen Prozessor (51) umfasst, der eingerichtet ist, um folgende Schritte auszuführen:

- Erhalten (3105, 3120) einer Widerstandsabschätzung basierend auf einer Abfolge von mindestens zwei Spannung-Strom-Wertepaaren mindestens einer Batteriezelle einer Batterie (91-96), wobei die Abfolge der mindestens zwei Spannung-Strom-Wertepaare assoziiert ist mit bestimmten Werten für mindestens zwei Betriebsparameter der mindestens einen Batteriezelle der Batterie, und
- basierend auf der Widerstandsabschätzung, Ändern (3125) eines Eintrags in einer Datenstruktur, der mit den bestimmten Werten für die mindestens zwei Betriebsparameter assoziiert ist,

wobei der Eintrag zumindest eine statistische Kenngröße einer Vielzahl von Widerstandsabschätzungen für die mindestens zwei Betriebsparameter umfasst, wobei die Vielzahl von Widerstandsabschätzungen die Widerstandsabschätzung und mehrere weitere Widerstandsabschätzungen für die bestimmten Werte der mindestens zwei Betriebsparameter umfasst.

**15.** Gerät (81) nach Anspruch 10, wobei der Prozessor (51) eingerichtet ist, um das Verfahren nach einem der Ansprüche 1 bis 13 auszuführen.

# FIG. 1

## FIG. 2

## FIG. 3

# FIG. 4

3005 — Befüllen der Datenstruktur

3010 — Auswertung

FIG. 5

# FIG. 6

```
3105 ──┤  Erhalte mindestens 2 U-I-Paare  │

3110 ──┤  Vorfiltern  │

3115 ──◇  Aggregieren  ◇  Ja

        Nein

3120 ──┤  Bestimmen Widerstandsabschätzung  │

3125 ──┤  Zugriff Datenstruktur  │

3130 ──┤  Statistische Auswertung  │

3131 ──┤  Modellbasierte Auswertung  │

3135 ──┤  Nachfiltern  │
```

Europäisches
Patentamt

European
Patent Office

Office européen
des brevets

# EUROPÄISCHER RECHERCHENBERICHT

**Nummer der Anmeldung**

**EP 21 20 5917**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | EP 3 605 127 A1 (LG CHEMICAL LTD [KR]) 5. Februar 2020 (2020-02-05) * Zusammenfassung; Abbildungen 1-3 * * Absätze [0013] - [0024], [0038] - [0054], [0114] - [0123] * ----- | 1-11, 13-15 | INV. G01R31/389 |
| X | EP 1 688 754 A2 (FUJI HEAVY IND LTD [JP]) 9. August 2006 (2006-08-09) * Zusammenfassung; Abbildungen 1-11 * * Absätze [0006], [0012] - [0023], [0028] - [0030], [0035] - [0047] * ----- | 1,12,14, 15 | |

**RECHERCHIERTE SACHGEBIETE (IPC)**

**G01R**

Der vorliegende Recherchenbericht wurde für alle Patentansprüche erstellt

| Recherchenort | Abschlußdatum der Recherche | Prüfer |
|---|---|---|
| **München** | **5. April 2022** | **Kleiber, Michael** |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

.......................................................................
& : Mitglied der gleichen Patentfamilie, übereinstimmendes Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 21 20 5917

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

05-04-2022

| Im Recherchenbericht angeführtes Patentdokument | Datum der Veröffentlichung | Mitglied(er) der Patentfamilie | Datum der Veröffentlichung |
|---|---|---|---|
| EP 3605127 A1 | 05-02-2020 | CN 110462414 A | 15-11-2019 |
| | | EP 3605127 A1 | 05-02-2020 |
| | | JP 6863560 B2 | 21-04-2021 |
| | | JP 2020514757 A | 21-05-2020 |
| | | KR 20190056743 A | 27-05-2019 |
| | | US 2021103001 A1 | 08-04-2021 |
| | | WO 2019098722 A1 | 23-05-2019 |
| EP 1688754 A2 | 09-08-2006 | EP 1688754 A2 | 09-08-2006 |
| | | JP 4638251 B2 | 23-02-2011 |
| | | JP 2006215001 A | 17-08-2006 |
| | | US 2006176022 A1 | 10-08-2006 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- **PETZL, MATHIAS ; MICHAEL A. DANZER.** Advancements in OCV measurement and analysis for lithium-ion batteries. *IEEE Transactions on energy conversion,* 2013, vol. 28 (3), 675-681